# EUROPEAN PATENT APPLICATION

(11) **EP 4 715 820 A1**
(43) Date of publication of application: **25.03.2026**
(21) Application number: 24883775.9
(22) Date of filing: 26.03.2024
(51) Int. Cl.: G11C 11/4091

(54) **SENSE AMPLIFIER, CONTROL METHOD THEREFOR, STORAGE ARRAY STRUCTURE, AND MEMORY**

(30) Priority: 03.11.2023 CN 202311460221
(71) Applicant: Beijing Superstring Academy of Memory Technology, Beijing 100176 (CN)
(72) Inventor: NA, Onegyun, Beijing 100176 (CN); WANG, Weitao, Beijing 100176 (CN)
(74) Representative: Gulde & Partner
(86) International application number: PCT/CN2024/083932
(87) International publication number: WO 2025/091760

(57) **Abstract**

The embodiments of the present disclosure relate to the technical field of storage, and provide a sense amplifier, a control method therefor, a storage array structure, and a memory. The sense amplifier comprises: a first signal amplification unit, wherein a first end and a second end of the first signal amplification unit are respectively adapted to be electrically connected to a first voltage end and a second voltage end, and a third end and a fourth end of the first signal amplification unit are respectively used as a first node and a second node; and a second signal amplification unit, wherein a first end, a second end and a third end of the second signal amplification unit are respectively adapted to be electrically connected to a third voltage end, a fourth voltage end and a bit line, and a fourth end of the second signal amplification unit is electrically connected to the first node. The sense amplifier is configured to amplify the voltage of the first node to a first voltage or a second voltage in a first signal amplification stage; and to write the second voltage or the first voltage back to a storage unit in a second signal amplification stage. The structure of the sense amplifier in the embodiments of the present disclosure can replace an edge reference array, and no additional reference array needs to be provided, thereby reducing the size of chips and reducing the chip cost.

## Description

### TECHNICAL FIELD

The present disclosure relates to the technical field of storage, and in particular to a sense amplifier and a control method therefor, and a memory array structure and a memory.

### BACKGROUND

At present, in most dynamic random access memories (DRAMs), the chip size is decreased by using an open bit-line (open BL) structure, thereby reducing the chip cost.

However, in the open bit-line structure, a reference voltage for each bit line is derived from a neighboring memory cell at the other side, and each instance of sense amplification of a signal of a bit line needs the reference voltage. The defect of this existing structure is that it is necessary to provide an additional reference array at the edge of each memory cell within a memory array structure, which must be controlled by control logic corresponding to the reference array. This results in a larger overall chip area and increases the chip size.

### SUMMARY

With respect to the defect of existing methods, the present disclosure provides a sense amplifier and a control method therefor, and a memory array structure and a memory, which are used for solving the technical problem in the prior art of increasing the chip size by the provision of additional reference arrays.

In a first aspect, an embodiment of the present disclosure provides a sense amplifier, comprising:
a first signal amplification unit, a first terminal and a second terminal of which are respectively used for being electrically connected to a first voltage terminal and a second voltage terminal, and a third terminal and a fourth terminal of which respectively serve as a first node and a second node, wherein the first voltage terminal is used for outputting a first voltage, the second voltage terminal is used for outputting a second voltage, and the first voltage is greater the second voltage; and
a second signal amplification unit, a first terminal, a second terminal and a third terminal of which are respectively used for being electrically connected to a third voltage terminal, a fourth voltage terminal and a bit line, and a fourth terminal of which is electrically connected to the first node, wherein a voltage at the third voltage terminal is the same as a voltage at the first voltage terminal, and a voltage at the fourth voltage terminal is the same as a voltage at the second voltage terminal; the bit line is used for being electrically connected to a memory cell of a memory array structure; and
the sense amplifier is configured in such a way that the first terminal, the first node and the second terminal of the first signal amplification unit are electrically connected in a first signal amplification stage so that a voltage at the first node is amplified to the first voltage or the second voltage, and the first terminal and the third terminal of the second signal amplification unit are electrically connected or the second terminal and the third terminal thereof are electrically connected in a second signal amplification stage so that a voltage of the bit line is amplified to the second voltage or the first voltage, so as to write the second voltage or the first voltage back to the memory cell.

**In** a second aspect, an embodiment of the present disclosure provides a memory array structure, comprising: a plurality of bit lines, a plurality of word lines, a plurality of memory cells, which are distributed in a matrix, and a plurality of sense amplifiers according to the first aspect,
wherein one of the bit lines is correspondingly electrically connected to one column of the memory cells;
one of the word lines is correspondingly electrically connected to one row of the memory cells; and
each of the bit lines is correspondingly electrically connected to a third terminal of a second signal amplification unit of one of the sense amplifiers.

In a third aspect, an embodiment of the present disclosure provides a dynamic random access memory, comprising: the memory array structure in the second aspect.

In a fourth aspect, an embodiment of the present disclosure provides an electronic device, comprising: the memory array structure according to the second aspect or the dynamic random access memory according to the third aspect.

In a fifth aspect, an embodiment of the present disclosure provides a control method, which is applied to the sense amplifier according to the first aspect, and comprises:
a first signal amplification stage, controlling a first terminal, a first node and a second terminal of a first signal amplification unit to electrically connect so that a voltage at the first node is amplified to a first voltage or a second voltage; and
a second signal amplification stage, controlling a first terminal and a third terminal of a second signal amplification unit to electrically connect or a second terminal and the third terminal thereof to electrically connect, so that a voltage of a bit line is amplified to the second voltage or the first voltage, so as to write the second voltage or the first voltage back to the memory cell of the memory array structure.

The beneficial technical effects that the technical solutions provided by the embodiments of the present disclosure bring about comprise:
the sense amplifier of the embodiment of the present disclosure may allow the voltage at the first node to be amplified to the first voltage or the second voltage by means of the first signal amplification unit in the first signal amplification stage, and allow the voltage of the bit line to be correspondingly amplified to the second voltage or the first voltage by means of the second signal amplification unit in the second signal amplification stage, so as to write the second voltage or the first voltage back to the memory cell, thereby improving the data write-back effect. In the embodiments of the present disclosure, a novel sense amplifier is designed, which may realize the sense amplification of the signal on the basis of the first signal amplification unit and the second signal amplification unit of the sense amplifier. When the sense amplifier is applied to the memory, there is no need to provide reference arrays at the edges within the memory array structure of the memory, such that the area overheads required for the reference arrays at the edges in an open bit-line structure are significantly reduced, thereby decreasing the chip size. Moreover, according to the embodiments of the present disclosure, the second signal amplification unit may be additionally designed in an existing sense amplifier, and the reference arrays at the edges are replaced by means of optimizing the structure of the sense amplifier, thus decreasing the chip size and reducing the chip cost.

Additional aspects and advantages of the present disclosure will be provided in the following description part, and will become apparent from the following description or be understood by means of the practice of the present disclosure.

### BRIEF DESCRIPTION OF THE DRAWINGS

The above and/or additional aspects and advantages of the present disclosure will become apparent and readily comprehensible from the following description of embodiments in conjunction with the accompanying drawings, in which:
FIG. 1 is a schematic structural diagram of a first type of sense amplifier provided in an embodiment of the present disclosure;
FIG. 2 is a schematic structural diagram of a second type of sense amplifier provided in an embodiment of the present disclosure;
FIG. 3 is a schematic structural diagram of a third type of sense amplifier provided in an embodiment of the present disclosure;
FIG. 4 is a schematic structural diagram of a fourth type of sense amplifier provided in an embodiment of the present disclosure;
FIG. 5 is a schematic structural diagram of a fifth type of sense amplifier provided in an embodiment of the present disclosure;
FIG. 6 is a schematic structural diagram of a sixth type of sense amplifier provided in an embodiment of the present disclosure;
FIG. 7 is a schematic structural diagram of a seventh type of sense amplifier connected to the memory cell provided in an embodiment of the present disclosure;
FIG. 8 is a schematic structural diagram of the seventh type of sense amplifier connected to the memory cell and a port provided in the embodiment of the present disclosure;
FIG. 9 is a schematic structural diagram of a memory array structure provided in an embodiment of the present disclosure;
FIG. 10 is a flowchart of a control method provided in an embodiment of the present disclosure;
FIG. 11 is a flowchart of another control method provided in an embodiment of the present disclosure;
FIG. 12 is a flowchart of still another control method provided in an embodiment of the present disclosure;
FIG. 13 is a timing control diagram of a sense amplifier provided in an embodiment of the present disclosure;
FIG. 14 is a schematic diagram of five stages that are included in the timing control diagram according to FIG. 13;
FIG. 15 is a timing control diagram of another sense amplifier provided in an embodiment of the present disclosure; and
FIG. 16 is a schematic diagram of seven stages that are included in the timing control diagram according to FIG. 15.

Reference signs:
10-sense amplifier;
110-first signal amplification unit, 111-fifth switch module; 112-sixth switch module;
113-seventh switch module, and 114-eighth switch module;
120-second signal amplification unit, 121-first switch module, and 122-second switch module;
130-third signal amplification unit, 131-third switch module, and 132-fourth switch module;
140-first isolation unit;
150-second isolation unit;
160-third isolation unit;
170-first pre-charge unit;
180-second pre-charge unit;
190-fourth isolation unit, 191-ninth switch module, and 192-tenth switch module;
1100-offset cancellation unit, 1101-eleventh switch module, and 1102-twelfth switch module; A-first node, B-second node, C-third node, D-fourth node; and
20-memory unit.

### DETAILED DESCRIPTION

The present disclosure will be described in detail below. Examples of the embodiments of the present disclosure are shown in the drawings, and throughout the drawings, the same or similar reference signs refer to the same or similar components or components having the same or similar functions. In addition, the detailed description of known techniques will be omitted if unnecessary to the shown features of the present disclosure. The embodiments described below with reference to the accompanying drawings are exemplary and are merely intended to explain the present disclosure, but should not be construed as limiting the present disclosure.

It should be understood by those skilled in the art that, unless otherwise defined, all terms (including technical and scientific terms) used herein have the same meaning as commonly understood by those of ordinary skills in the art. It should also be understood that terms, such as those defined in commonly used dictionaries, should be construed as having meanings that are consistent with their meanings in the context of the prior art, and will not be construed in an idealized or overly formal sense unless specifically defined as here.

It should be understood by those skilled in the art that, as used herein, the singular form "a", "an" or "the" may include plural forms as well, unless otherwise stated. It should be further understood that the term "include" used in the specification of the present disclosure specifies the presence of the features, integers, steps, operations, elements and/or components, but does not exclude the presence or addition of one or more of other features, integers, steps, operations, elements, components and/or their combinations. It should be understood that, when an element is referred to be "connected to" or "coupled to" another element, this element may be directly connected to or coupled to the another element, or this element may be connected to the another element through an intermediate element. In addition, "connecting" or "coupling" used herein may include wireless connection or wireless coupling. The term "and/or" used herein indicates all or any units and all combinations of one or more items listed in association.

The technical solution of the present disclosure, and how the technical solution of the present disclosure solves the above technical problems will be described below in details with particular embodiments.

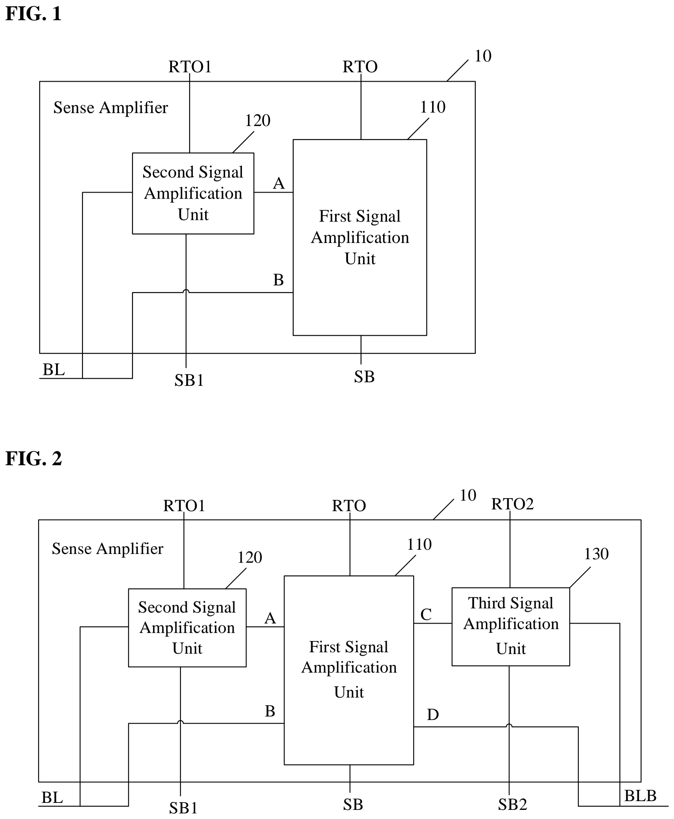

An embodiment of the present disclosure provides a sense amplifier. Referring to FIG. 1, the sense amplifier 10 includes a first signal amplification unit 110 and a second signal amplification unit 120.

A first terminal and a second terminal of the first signal amplification unit 110 are respectively used for being electrically connected to a first voltage terminal and a second voltage terminal, and a third terminal and a four terminal of the first signal amplification unit 110 respectively serve as a first node A and a second node B. The first voltage terminal is used for outputting a first voltage, the second voltage terminal is used for outputting a second voltage, and the first voltage is greater than the second voltage.

Optionally, referring to FIG. 1, a voltage signal output from the first voltage terminal is RTO, and a voltage signal output from the second voltage terminal is SB. The first voltage terminal and the second voltage terminal are power supply terminals, providing two power supply signals. A switch device may be provided between the first voltage terminal and the first terminal of the first signal amplification unit 110, and when the switch device is turned on, the first voltage terminal is activated and enters an operating state. Similarly, a switch device may be provided between the second terminal of the first signal amplification unit 110 and the second voltage terminal, and when the switch device is turned on, the second voltage terminal is activated and enters the operating state.

Optionally, RTO is 0.5 V when in a non-operating state, and is 1.0 V when in the operating state; and SB is 0.5 V when in the non-operating state, and is 0 V when in the operating state. When in the operating state, the first voltage may be 1 V, and the second voltage may be 0 V. A first terminal, a second terminal and a third terminal of the second signal amplification unit 120 are respectively used for being electrically connected to a third voltage terminal, a fourth voltage terminal and a bit line, and a fourth terminal of the second signal amplification unit 120 is electrically connected to the first node A. A voltage at the third voltage terminal is the same as a voltage at the first voltage terminal, and a voltage at the fourth voltage terminal is the same as a voltage at the second voltage terminal.

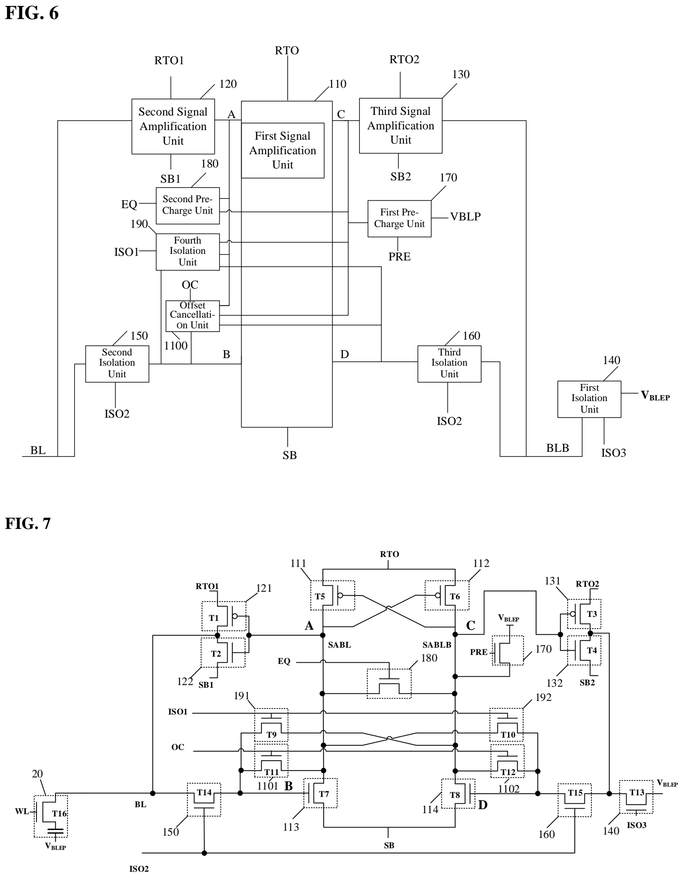

As shown in FIG. 1 and FIG. 7, the bit line (BL) is used for being electrically connected to a memory cell 20 of a memory array structure, the BL may be used for data transmission and locating, and the BL may also be used for being electrically connected to the second node B. Optionally, referring to FIG. 1, a voltage signal output from the third voltage terminal is RTO1, a voltage signal output from the fourth voltage terminal is SB1, and the third voltage terminal and the fourth voltage terminal are respectively equivalent to the first voltage terminal and the second voltage terminal, and are also power supply terminals, providing two power supply signals. Optionally, RTO1 is 0.5 V when in the non-operating state, and is 1.0 V when in the operating state, which is the same as RTO. When in the operating state, a voltage at the third voltage terminal is the first voltage, which may be 1 V, and SB1 is 0 V.

The sense amplifier 10 is configured in such a way that the first terminal, the first node A and the second terminal of the first signal amplification unit 110 are electrically connected in a first signal amplification stage so that a voltage at the first node A is amplified to the first voltage or the second voltage, and the first terminal and the third terminal of the second signal amplification unit 120 are electrically connected or the second terminal and the third terminal thereof are electrically connected in a second signal amplification stage so that a voltage of the bit line is amplified to the second voltage or the first voltage, so as to write the second voltage or the first voltage back to the memory cell 20.

Specifically, the first terminal and the third terminal, or the second terminal and the third terminal of the second signal amplification unit 120 are electrically connected under the control of the first node A, and the voltage at the first node A is the second voltage or the first voltage, which may correspondingly control the electrical connection between the first terminal and the third terminal of the second signal amplification unit 120 or between the second terminal and the third terminal thereof.

As an example, the sense amplifier 10 may be configured in such a way that the first terminal, the first node A and the second terminal of the first signal amplification unit 110 are electrically connected in the first signal amplification stage so that the voltage at the first node A is amplified to the first voltage, and the second terminal and the third terminal of the second signal amplification unit 120 are electrically connected in the second signal amplification stage so that the voltage of the bit line is amplified to the second voltage, so as to write the second voltage back to the memory cell 20.

At present, a DRAM memory cell is of a 1T1C structure, which occupies a large area and involves a complex manufacturing process. A sense amplifier is generally of a simple metal oxide semiconductor (MOS) field effect transistor structure, which is simple to manufacture and occupies a small area. Since each instance of sense amplification in open BL of DRAM needs a reference voltage, reference arrays need to be provided at edges in all the conventional DRAMs, and memory cells serve as a sense reference during reading and writing. The sense amplifier 10 provided in the embodiment of the present disclosure is a novel structural design, which may realize sense amplification by only using a single sense amplifier 10, without needing the additional manufacturing of the reference arrays, thereby decreasing the chip area.

The sense amplifier 10 of the embodiment of the present disclosure may allow the voltage at the first node A to be amplified to the first voltage or the second voltage by means of the first signal amplification unit 110 in the first signal amplification stage, and allow the voltage of the bit line to be amplified to the second voltage or the first voltage by means of the second signal amplification unit 120 in the second signal amplification stage, so as to write the second voltage or the first voltage back to the memory cell 20, thereby improving the data write-back effect. A novel sense amplifier 10 is designed in the embodiment of the present disclosure. The sense amplifier 10 may realize the sense amplification of a signal on the basis of the first signal amplification unit 110 and the second signal amplification unit 120 of the sense amplifier. When the sense amplifier is applied to a memory, there is no need to provide reference arrays at the edges within a memory array structure of the memory, such that the area overheads required for the reference arrays at the edges in an open bit-line structure are significantly reduced, thereby decreasing the chip size. Moreover, according to the embodiments of the present disclosure, the second signal amplification unit 120 may be additionally designed in an existing sense amplifier, and the reference arrays at the edges are replaced by means of optimizing the structure of the sense amplifier 10, thus decreasing the chip size and reducing the chip cost.

Similarly, the sense amplifier 10 may further be configured in such a way that the first terminal, the first node A and the second terminal of the first signal amplification unit 110 are electrically connected in the first signal amplification stage so that the voltage at the first node A is amplified to the second voltage, and the first terminal and the third terminal of the second signal amplification unit 120 are electrically connected in the second signal amplification stage so that the voltage of the bit line is amplified to the first voltage, so as to write the first voltage back to the memory cell 20.

In some embodiments, referring to FIG. 2, a fifth terminal and a sixth terminal of the first signal amplification unit 110 respectively serve as a third node C and a fourth node D.

The sense amplifier 10 further includes a third signal amplification unit 130.

A first terminal, a second terminal and a third terminal of the third signal amplification unit 130 are respectively used for being electrically connected to a fifth voltage terminal, a sixth voltage terminal and a first data signal line, and a fourth terminal of the third signal amplification unit 130 is electrically connected to the third node C. A voltage at the fifth voltage terminal is the same as the voltage at the first voltage terminal, and a voltage at the sixth voltage terminal is the same as the voltage at the second voltage terminal. The first data signal line is used for being electrically connected to a port.

Referring to FIG. 2, a voltage signal output from the fifth voltage terminal is RTO2, a voltage signal output from the sixth voltage terminal is SB2, and the fifth voltage terminal and the sixth voltage terminal are respectively equivalent to the first voltage terminal and the second voltage terminal, and are also power supply terminals, providing two power supply signals. Optionally, RTO2 is 0.5 V when in the non-operating state, and is 1.0 V when in the operating state, which is the same as RTO. When in the operating state, a voltage at the fifth voltage terminal is the first voltage, which may be 1 V; and when in the operating state, a voltage at the sixth voltage terminal is the second voltage, which may be 0 V.

The sense amplifier 10 is further configured in such a way that the first terminal, the third node C and the second terminal of the first signal amplification unit 110 are electrically connected in the first signal amplification stage so that a voltage at the third node C is amplified to the second voltage or the first voltage; and the first terminal and the third terminal of the third signal amplification unit 130 are electrically connected or the second terminal and the third terminal thereof are electrically connected in the second signal amplification stage so that a voltage of the first data signal line is amplified to the first voltage or the second voltage, so as to output the first voltage or the second voltage to the port.

Specifically, the first terminal and the third terminal of the third signal amplification unit 130, or the second terminal and the third terminal thereof are electrically connected under the control of the third node C, the voltage at the third node C is the second voltage or the first voltage, and may correspondingly control the electrical connection between the first terminal and the third terminal of the third signal amplification unit 130 and the electrical connection between the second terminal and the third terminal thereof.

As an example, the sense amplifier 10 may be configured in such a way that the first terminal, the third node C and the second terminal of the first signal amplification unit 110 are electrically connected in the first signal amplification stage so that the voltage at the third node C is amplified to the second voltage; and the first terminal and the third terminal of the third signal amplification unit 130 are electrically connected in the second signal amplification stage so that the voltage of the first data signal line is amplified to the first voltage, so as to output the first voltage to the port.

Specifically, the structure of the third signal amplification unit 130 is consistent with that of the second signal amplification unit 120, and the third signal amplification unit 130 and the second signal amplification unit 120 are equivalent to two inverter structures, which are used for data recovery.

Optionally, referring to FIG. 2, the third signal amplification unit 130 and the second signal amplification unit 120 are disposed at two sides of the first signal amplification unit 110 to form a symmetrical structure. Considering that the bit line BL and the first data signal line BLB at two sides of the first signal amplification unit 110 have different loads, with the bit line BL being connected to the memory cell 20 and the first data signal line BLB not being connected to the memory cell 20, to avoid data errors due to the interference with readout, a relatively small voltage difference between the bit line BL and the first data signal line BLB is sensed and amplified onto the first node A and the third node C through a first instance of signal amplification. Then, during a second instance of signal amplification, voltage signals of the bit line BL and the first data signal line BLB are amplified by means of the second signal amplification unit 120 and the third signal amplification unit 130, thereby ensuring the reliability of the amplification process.

Similarly, the sense amplifier 10 is further configured in such a way that the first terminal, the third node C and the second terminal of the first signal amplification unit 110 are electrically connected in the first signal amplification stage so that the voltage at the third node C is amplified to the first voltage; and the second terminal and the third terminal of the third signal amplification unit 130 are electrically connected in the second signal amplification stage so that the voltage of the first data signal line is amplified to the second voltage, so as to output the second voltage to the port.

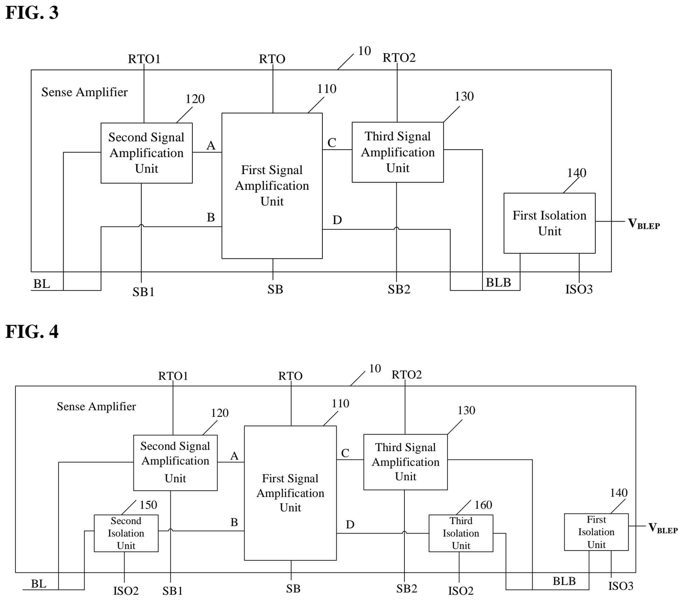

In some embodiments, referring to FIG. 3, the sense amplifier 10 further includes a first isolation unit 140.

A control terminal of the first isolation unit 140 is used for being electrically connected to a first isolation signal line, and a first terminal and a second terminal of the first isolation unit 140 are respectively used for being electrically connected to a first reference voltage terminal and the first data signal line.

The first isolation unit 140 is configured in such a way that the first terminal and the second terminal of the first isolation unit 140 are electrically disconnected in the second signal amplification stage, so as to amplify the voltage of the first data signal line.

As an example, the first isolation unit 140 may be configured in such a way that the first terminal and the second terminal of the first isolation unit 140 are electrically disconnected in the second signal amplification stage, so as to amplify the voltage of the first data signal line to the first voltage or the second voltage. Referring to FIG. 7, during a first instance of sense amplification on an SABL (the first node A), a voltage of the SABL may have difference values depending on whether the memory cell 20 stores 0 or 1. If 0 is stored, the voltage of the SABL is the first voltage (RTO), and during a second instance of signal amplification, a voltage written back from the bit line BL is a voltage of SB1. Conversely, if the memory cell 20 stores 1, the voltage of the SABL is the second voltage (SB), and during the second instance of signal amplification, the voltage of RTO1 is written back from the BL.

Referring to FIG. 3, a control signal received by the first isolation unit is ISO3, and a reference voltage of the first reference voltage terminal is V_{BLEP}. The ISO3 may control the electrical connection and electrical disconnection between the first terminal and the second terminal of the first isolation unit 140. When the first terminal and the second terminal of the first isolation unit 140 are electrically disconnected, the voltage of the first data signal line BLB is isolated from the reference voltage VBLP of the first reference voltage terminal and no longer affected by the reference voltage VBLP, thereby eliminating the signal problems caused by edge reference voltages. The first reference voltage terminal may be a power supply of 0.5 V, that is, V_{BLEP} may be 0.5 V.

In some embodiments, referring to FIG. 4, the sense amplifier 10 further includes a second isolation unit 150.

A control terminal and a first terminal of the second isolation unit 150 are respectively used for being electrically connected to a second isolation signal line and the bit line, and a second terminal of the second isolation unit 150 is electrically connected to the second node B.

The second isolation unit 150 is configured in such a way that the first terminal and the second terminal of the second isolation unit 150 are electrically connected when in an operating state, and the first terminal and the second terminal of the second isolation unit 150 are electrically disconnected when in a non-operating state.

Referring to FIG. 4, a control signal received by the second isolation signal line is ISO2, which may control the electrical connection and electrical disconnection between the first terminal and the second terminal of the second isolation unit 150. When the first terminal and the second terminal of the second isolation unit 150 are electrically disconnected, the bit line and the second node B are electrically disconnected, and the sense amplifier 10 is also electrically disconnected from the port, so as to cut off a loading effect of the port, thereby avoiding the influence on the read and write effect.

In some embodiments, referring to FIG. 4, the sense amplifier 10 further includes a third isolation unit 160.

A control terminal of the third isolation unit 160 is used for being electrically connected to a third isolation signal line, and a first terminal and a second terminal of the third isolation unit 160 are electrically connected to the first data signal line and the fourth node D, respectively. The third isolation signal line is electrically connected to the second isolation signal line. The third isolation unit 160 is configured in such a way that the first terminal and the second terminal of the third isolation unit 160 are electrically connected when in an operating state, and the first terminal and the second terminal of the third isolation unit 160 are electrically disconnected when in a non-operating state.

Referring to FIG. 4, the configuration principle of the third isolation unit 160 is the same as that of the second isolation unit 150. A control signal received by the third isolation signal line is ISO2, which may control the electrical connection and electrical disconnection between the first terminal and the second terminal of the third isolation unit 160. When the first terminal and the second terminal of the third isolation unit 160 are electrically disconnected, the first data signal line and the fourth node D are electrically disconnected. Since the bit line and the first data signal line are both connected to the port and respectively output an IO and an inverted signal IOB of the IO, the sense amplifier 10 may be electrically disconnected from the port by means of the control signal ISO2, so as to cut off a loading effect of the port, thereby avoiding the influence on the read and write effect.

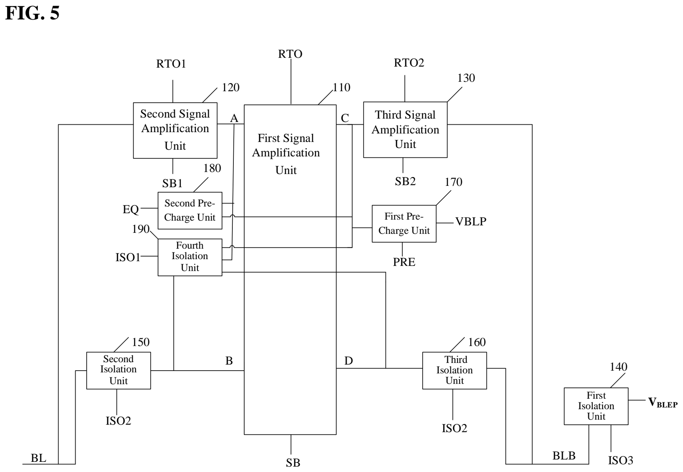

In some embodiments, referring to FIG. 5, the sense amplifier 10 further includes a first pre-charge unit 170, a second pre-charge unit 180 and a fourth isolation unit 190.

A control terminal of the first pre-charge unit 170 is used for being electrically connected to a first signal line, a first terminal of the first pre-charge unit 170 is used for being electrically connected to the first reference voltage terminal, and a second terminal of the first pre-charge unit 170 is electrically connected to the third node C. The first reference voltage terminal is used for outputting a first reference voltage.

A control terminal of the second pre-charge unit 180 is used for being electrically connected to a second signal line, and a first terminal and a second terminal of the second pre-charge unit 180 are electrically connected to the first node A and the third node C, respectively.

A control terminal of the fourth isolation unit 190 is used for being electrically connected to a fourth isolation signal line, and a first terminal, a second terminal, a third terminal and a fourth terminal of the fourth isolation unit 190 are electrically connected to the second node B, the third node C, the first node A and the fourth node D, respectively.

Referring to FIG. 5, a reference voltage output from the first reference voltage terminal is V_{BLEP}, a control signal output from the first signal line is PRE, a control signal output from the second signal line is EQ, and a control signal output from the fourth isolation signal line is ISO1. The PRE may control the electrical connection and the electrical disconnection between the first terminal and the second terminal of the first pre-charge unit 170, the EC may control the electrical connection and the electrical disconnection between the first terminal and the second terminal of the second pre-charge unit 180, and the ISO1 may control the electrical connection and electrical disconnection between the first terminal and the second terminal of the fourth isolation unit 190 and between the third terminal and the fourth terminal thereof.

The sense amplifier 10 is further configured to, in the first pre-charge stage, control the first terminal and the second terminal of the first pre-charge unit 170 to electrically connect, control the first terminal and the second terminal of the second pre-charge unit 180 to electrically connect, control the first terminal and the second terminal of the fourth isolation unit 190 to electrically connect and the third terminal and the fourth terminal thereof to electrically connect, and control the first terminal and the second terminal of the first isolation unit 140 to electrically connect, so as to pre-charge the first node A, the third node C, the bit line and the first data signal line to a predetermined voltage.

The sense amplifier 10 is further configured to, in the charge sharing stage, control the first terminal and the second terminal of the first pre-charge unit 170 to electrically disconnect, control the first terminal and the second terminal of the second pre-charge unit 180 to electrically disconnect, and control charge sharing to perform between the predetermined voltage of the bit line and capacitance of the memory cell 20.

Specifically, the predetermined voltage is a reference voltage, and V_{BLEP} may be 0.5 V.

Specifically, referring to FIG. 7, each memory cell 20 of the memory array structure is formed of a 1T1C structure, and by means of controlling a control signal WL of a word line, charge sharing may be controlled to be performed between the bit line BL and the capacitor of the memory cell 20. Charge redistribution occurs between a load capacitor on the bit line BL and a storage capacitor of the memory cell 20, sharing an internally stored voltage to the bit line BL. The voltage of the bit line BL is no longer 0.5 V after the charge sharing is performed. If the memory cell 20 stores 0 V, the voltage of the bit line BL is less than 0.5 V, and if the memory cell 20 stores 1 V, the voltage of the bit line BL is greater than 0.5 V.

The sense amplifier 10 is further configured to, in the first amplification stage, control the first terminal and the second terminal of the fourth isolation unit 190 to electrically disconnect and the third terminal and the fourth terminal thereof to electrically disconnect, and control the first terminal, the third node C and the second terminal of the first signal amplification unit 110 to electrically connect, so that the voltage at the third node C is amplified to first voltage or second voltage; and in the second signal amplification stage, control the first terminal and the second terminal of the first isolation unit 140 to electrically disconnect, control the first terminal and the second terminal of the fourth isolation unit 190 to electrically connect and the third terminal and the fourth terminal thereof to electrically connect, and control the first terminal and the third terminal of the third signal amplification unit 130 of the sense amplifier 10 to electrically connect or the second terminal and the third terminal thereof to electrically connect, so that the voltage of the first data signal line is amplified to the second voltage or the first voltage, so as to output the second voltage or the first voltage to the port.

Optionally, the sense amplifier 10 is further configured to, in a second pre-charge stage, control the first terminal, the first node A and the second terminal of the first signal amplification unit 110 to electrically disconnect, control the first terminal, the third node C and the second terminal of the first signal amplification unit 110 to electrically disconnect, control the first terminal and the third terminal of the second signal amplification unit 120 to electrically disconnect and the second terminal and the third terminal thereof to electrically disconnect, control the first terminal and the third terminal of the third signal amplification unit 130 to electrically disconnect and the second terminal and the third terminal thereof to electrically disconnect, control the bit line to electrically disconnect from the memory cell 20, control the first terminal and the second terminal of the first pre-charge unit 170 to electrically connect, and control the first terminal and the second terminal of the second pre-charge unit 180 to electrically connect, so as to pre-charge the first node A, the third node C, the bit line and the first data signal line to a predetermined voltage. The second pre-charge stage prepares for the next instance of data reading.

In some embodiments, referring to FIG. 6, the sense amplifier 10 further includes an offset cancellation unit 1100.

A control terminal of the offset cancellation unit 1100 is used for being electrically connected to an offset cancellation signal line, and a first terminal, a second terminal, a third terminal and a fourth terminal of the offset cancellation unit 1100 are electrically connected to the second node B, the first node A, the third node C and the fourth node D, respectively.

Referring to FIG. 6, a control signal output by the offset cancellation unit 1100 is OC, which may control the electrical connection and electrical disconnection between the first terminal and the second terminal of the offset cancellation unit 1100 and between the third terminal and the fourth terminal thereof.

As an example, the sense amplifier 10 is further configured to, in a third pre-charge stage, control the first terminal and the second terminal of the first pre-charge unit 170 of the sense amplifier 10 to electrically connect, control the first terminal and the second terminal of the second pre-charge unit 180 of the sense amplifier 10 to electrically connect, control the first terminal and the second terminal of the offset cancellation unit 1100 of the sense amplifier 10 to electrically connect and the third terminal and the fourth terminal thereof to electrically connect, and control the first terminal and the second terminal of the first isolation unit 140 of the sense amplifier 10 to electrically connect, so as to pre-charge the first node A, the third node C, the bit line and the first data signal line to a predetermined voltage.

The sense amplifier 10 is further configured to, in an offset cancellation stage, control the first terminal and the second terminal of the first pre-charge unit 170 to electrically disconnect, control the first terminal and the second terminal of the second pre-charge unit 180 to electrically disconnect, control the first terminal and the second terminal of the first isolation unit 140 to electrically disconnect, control the first terminal, the first node A and the second terminal of the first signal amplification unit 110 to electrically connect, and control the first terminal, the third node C and the second terminal of the first signal amplification unit 110 to electrically connect, so as to cancel offsets of threshold voltages of switch devices at the fourth terminal and the sixth terminal of the first signal amplification unit 110.

The sense amplifier 10 is further configured to, in a fourth pre-charge stage, control the first terminal and the second terminal of the offset cancellation unit 1100 to electrically disconnect and the third terminal and the fourth terminal thereof to electrically disconnect, control the first terminal and the second terminal of the first pre-charge unit 170 to electrically connect, and control the first terminal and the second terminal of the second pre-charge unit 180 to electrically connect, so as to pre-charge the first node A and the third node C to a predetermined voltage.

In some embodiments, referring to FIG. 7, the second signal amplification unit 120 includes a first switch module 121 and a second switch module 122.

A control terminal of the first switch module 121 and a control terminal of the second switch module 122 together serve as the fourth terminal of the second signal amplification unit 120. A first terminal of the first switch module 121 serves as the first terminal of the second signal amplification unit 120.

A second terminal of the second switch module 122 serves as the second terminal of the second signal amplification unit 120.

A second terminal of the first switch module 121 and a first terminal of the second switch module 122 together serve as the third terminal of second signal amplification unit 120.

Optionally, the first switch module 121 includes a first switch device T1, and the second switch module 122 includes a second switch device T2. A gate of the first switch device T1 is the control terminal of the first switch module, a source and a drain of the first switch device T1 are respectively the first terminal and the second terminal of the first switch module 121, a gate of the second switch device T2 is the control terminal of the second switch module 122, and a source and a drain of the second switch device T2 are respectively the first terminal and the second terminal of the second switch module 122. The specific configurations of the switch devices are made according to actual circuit requirements.

As an example, the first switch device T1 may be a PMOS, and the second switch device T2 may be an NMOS. The first terminal of the first switch module 121 is a source of the PMOS, the second terminal of the first switch module 121 is a drain of the PMOS, the first terminal of the second switch module 122 is a drain of the NMOS, and the second terminal of the second switch module 122 is a source of the NMOS.

In some embodiments, referring to FIG. 7, the third signal amplification unit 130 includes a third switch module 131 and a fourth switch module 132.

A control terminal of the third switch module 131 and a control terminal of the fourth switch module 132 together serve as the fourth terminal of the third signal amplification unit 130.

A first terminal of the third switch module 131 serves as the first terminal of the third signal amplification unit 130.

A second terminal of the fourth switch module 132 serves as the second terminal of the third signal amplification unit 130.

A second terminal of the third switch module 131 and a first terminal of the fourth switch module 132 together serve as the third terminal of the third signal amplification unit 130.

Optionally, referring to FIG. 7, the third switch module 131 includes a third switch device T3, and the fourth switch module 132 includes a fourth switch device T4. A gate of the third switch device T3 is the control terminal of the third switch module 131, a source and a drain of the third switch device T3 are respectively the first terminal and the second terminal of the third switch module 131, a gate of the fourth switch device T4 is the control terminal of the fourth switch module 132, and a source and a drain of the fourth switch device T4 are respectively the first terminal and the second terminal of the fourth switch module 132. The specific circuit connection is configured according to actual circuit requirements.

As an example, the third switch device T3 may be a PMOS, and the fourth switch device T4 may be an NMOS. The first terminal of the third switch module 131 is a source of the PMOS, the second terminal of the third switch module 131 is a drain of the PMOS, the first terminal of the fourth switch module 132 is a drain of the NMOS, and the second terminal of the fourth switch module 132 is a source of the NMOS.

In some embodiments, referring to FIG. 7, the first signal amplification unit 110 includes a fifth switch module 111, a sixth switch module 112, a seventh switch module 113 and an eighth switch module 114.

A first terminal of the fifth switch module 111 and a first terminal of the sixth switch module 112 together serve as the first terminal of the first signal amplification unit 110.

A second terminal of the fifth switch module 111 and a first terminal of the seventh switch module 113 together serve as the third terminal of the first signal amplification unit 110, and a second terminal of the sixth switch module 112 and a first terminal of the eighth switch module 114 together serve as the fifth terminal of the first signal amplification unit 110.

A second terminal of the seventh switch module 113 and a second terminal of the eighth switch module 114 together serve as the second terminal of the first signal amplification unit 110.

A control terminal of the fifth switch module 111 is electrically connected to the third node C, and a control terminal of the sixth switch module 112 is electrically connected to the first node A.

A control terminal of the seventh switch module 113 serves as the fourth terminal of the first signal amplification unit 110, and a control terminal of the eighth switch module 114 serves as the sixth terminal of the first signal amplification unit 110.

As an example, referring to FIG. 7, the fifth switch module 111 includes a fifth switch device T5, the sixth switch module 112 includes a sixth switch device T6, the seventh switch module 113 includes a seventh switch device T7, and the eighth switch module 114 includes an eighth switch device T8. The fifth switch device T5 and the sixth switch device T6 may be PMOSs, and the seventh switch device T7 and the eighth switch device T8 may be NMOSs. The specific configurations of the switch devices are made according to actual circuit requirements.

Optionally, gates of the fifth switch device T5, the sixth switch device T6, the seventh switch device T7 and the eighth switch device T8 are respectively the control terminals of the fifth switch module 111, the sixth switch module 112, the seventh switch module 113 and the eighth switch module 114, and sources and drains of the fifth switch device T5, the sixth switch device T6, the seventh switch device T7 and the eighth switch device T8 are respectively the first terminals and the second terminals of the fifth switch module 111, the sixth switch module 112, the seventh switch module 113 and the eighth switch module 114. In some embodiments, referring to FIG. 7, the fourth isolation unit 190 includes a ninth switch module 191 and a tenth switch module 192.

A control terminal of the ninth switch module 191 and a control terminal of the tenth switch module 192 together serve as the control terminal of the fourth isolation unit 190.

A first terminal and a second terminal of the ninth switch module 191 respectively serve as the second terminal and the first terminal of the fourth isolation unit 190.

A first terminal and a second terminal of the tenth switch module 192 respectively serve as the third terminal and the fourth terminal of the fourth isolation unit 190.

As an example, referring to FIG. 7, the ninth switch module 191 includes a ninth switch device T9, the tenth switch module 192 includes a tenth switch device T10, and the ninth switch device T9 and the tenth switch device T10 may be NMOSs. Gates of the ninth switch device T9 and the tenth switch device T10 are respectively the control terminals of the ninth switch module 191 and the tenth switch module 192, and sources and drains of the ninth switch device T9 and the tenth switch device T10 are respectively the first terminals and the second terminals of the ninth switch module 191 and the tenth switch module 192.

In some embodiments, referring to FIG. 7, the offset cancellation unit 1100 includes an eleventh switch module 1101 and a twelfth switch module 1102.

A control terminal of the eleventh switch module 1101 and a control terminal of the twelfth switch module 1102 together serve as the control terminal of the offset cancellation unit 1100. A first terminal and a second terminal of the eleventh switch module 1101 respectively serve as the second terminal and the first terminal of the offset cancellation unit 1100.

A first terminal and a second terminal of the twelfth switch module 1102 respectively serve as the third terminal and the fourth terminal of the offset cancellation unit 1100.

As an example, referring to FIG. 7, the eleventh switch module 1101 includes an eleventh switch device T11, the twelfth switch module 1102 includes a twelfth switch device T12, and the eleventh switch device T11 and the twelfth switch device T12 may be NMOSs. Gates of the eleventh switch device T11 and the twelfth switch device T12 are respectively the control terminals of the eleventh switch module 1101 and the twelfth switch module 1102, sources and drains of the eleventh switch device T11 and the twelfth switch device T12 are respectively the first terminals and the second terminals of the eleventh switch module 1101 and the twelfth switch module 1102.

Referring to FIG. 7, the first isolation unit 140 includes a thirteenth switch device T13, the second isolation unit 150 includes a fourteenth switch device T14, and the third isolation unit 160 includes a fifth switch device T15. Gates of the thirteenth switch device T13, the fourteenth switch device T14 and the fifth switch device T15 are respectively the control terminals of the first isolation unit 140, the second isolation unit 150 and the third isolation unit 160, sources and drains of the thirteenth switch device T13, the fourteenth switch device T14 and the fifth switch device T15 are respectively the first terminals and the second terminals of the first isolation unit 140, the second isolation unit 150 and the third isolation unit 160.

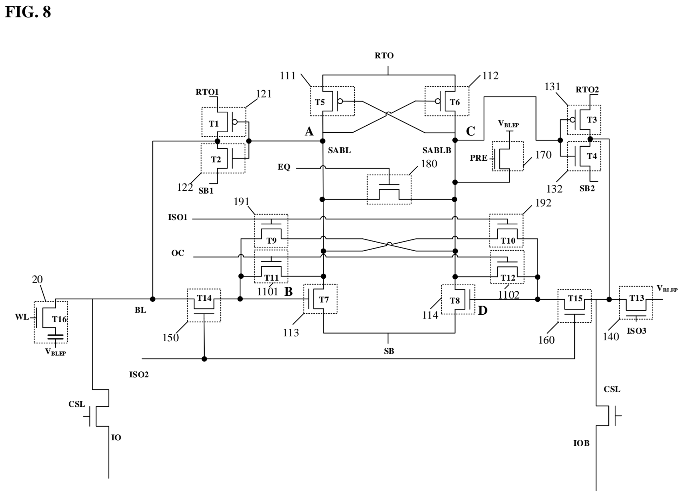

Referring to FIG. 8, it is a schematic structural diagram illustrating the sense amplifier connecting the memory cell 20 and a port. IOB is an inverted signal of IO and is output to the port. The second signal amplification unit 120 is related to RTO1 and SB1, and the third signal amplification unit 130 is related to RTO2 and SB2. The second signal amplification unit 120 and the third signal amplification unit 130 respectively provide the IO and the IOB. When RTO1 and SB1, and RTO2 and SB2 are all activated, if a data read operation is performed, RTO1 and SB1, and RTO2 and SB2 may improve the effect of data transmission through the port. After the switch device CSL is turned on, the stability of data on IO and IOB may be ensured, and thus the turning on of the switch device CSL may provide a data readout function. After the switch device CSL is turned off, the influence of IO loading on the read and write effect may be isolated.

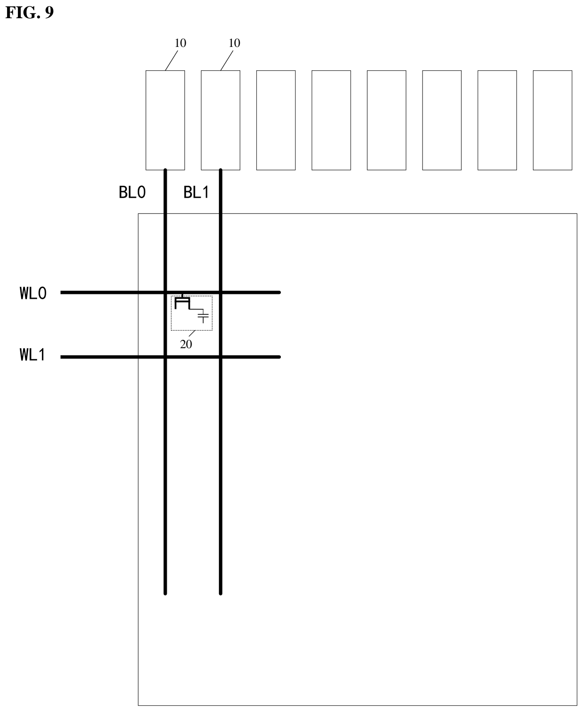

Based on the same inventive concept, an embodiment of the present disclosure provides a memory array structure. Referring to FIG. 9, the memory array structure includes: a plurality of bit lines, a plurality of word lines, a plurality of memory cells 20, which are distributed in a matrix, and a plurality of sense amplifiers 10 according to the embodiments of the present disclosure.

One of the bit lines is correspondingly electrically connected to one column of the memory cells 20.

One of the word lines is correspondingly electrically connected to one row of the memory cells 20.

Each of the bit lines is correspondingly electrically connected to a third terminal of a second signal amplification unit 120 of one of the sense amplifiers 10.

Referring to FIG. 7 to FIG. 9, each of the memory cell 20 includes a switch device 16 and a capacitor. A control terminal of the switch device 16 is electrically connected to a word line. The turning on and off of the switch device 16 is controlled by means of controlling an output control signal WL of the word line, so as to control the connection and disconnection between the memory cell 20 and the bit line BL.

It should be noted that the circuit connection method of the present disclosure is merely an example of the sense amplifier provided in the embodiments of the present disclosure, each switch device may be selected from among different transistors such as a PMOS or an NMOS according to requirements, electrical connection methods for elements in the sense amplifier provided in the embodiment of the present disclosure may be adaptively adjusted, and the adaptively adjusted electrical connection methods still fall within the scope of protection of the embodiments of the present disclosure.

Based on the same inventive concept, an embodiment of the present disclosure provides a dynamic random access memory, including: a memory array structure.

Based on the same inventive concept, an embodiment of the present disclosure provides an electronic device, including: the memory array structure according to the embodiment of the present disclosure or the dynamic random access memory according to the embodiment of the present disclosure.

The electronic device may be a mobile terminal such as a smart phone, a laptop computer, a digital broadcast receiver, a personal digital assistant (PDA), a PAD (tablet computer), a portable multimedia player (PMP), a vehicle-mounted terminal (e.g., a vehicle-mounted navigation terminal) and the like, and a fixed terminal such as a smart television, a desktop computer and the like.

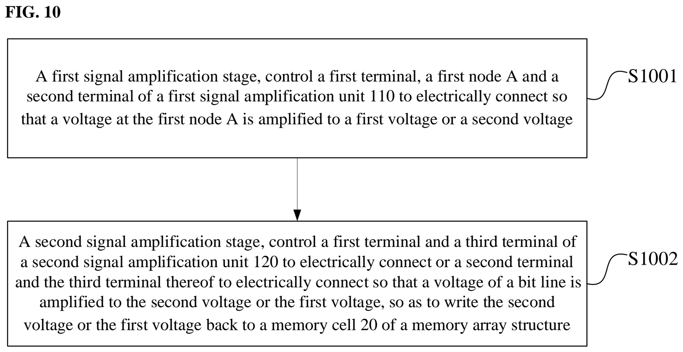

Based on the same inventive concept, an embodiment of the present disclosure provides a control method, which is applied to the sense amplifier 10 according to the embodiments of the present disclosure. Referring to FIG. 10, the control method includes:
S1001, a first signal amplification stage, controlling a first terminal, a first node A and a second terminal of a first signal amplification unit 110 to electrically connect so that a voltage at the first node A is amplified to a first voltage or a second voltage; and
S1002, a second signal amplification stage, controlling a first terminal and a third terminal of a second signal amplification unit 120 to electrically connect or a second terminal and the third terminal thereof to electrically connect so that a voltage of a bit line is amplified to the second voltage or the first voltage, so as to write the second voltage or the first voltage back to a memory cell 20 of a memory array structure.

In some embodiments, before the first signal amplification stage, the method further includes: a first pre-charge stage, controlling a first terminal and a second terminal of a first pre-charge unit 170 of a sense amplifier 10 to electrically connect, controlling a first terminal and a second terminal of a second pre-charge unit 180 of the sense amplifier 10 to electrically connect, controlling a first terminal and a second terminal of a fourth isolation unit 190 of the sense amplifier 10 to electrically connect and a third terminal and a fourth terminal thereof to electrically connect, and controlling a first terminal and a second terminal of a first isolation unit 140 of the sense amplifier 10 to electrically connect, so as to pre-charge the first node A, a third node C, the bit line and a first data signal line to a predetermined voltage, which is less than the first voltage; and
a charge sharing stage, controlling the first terminal and the second terminal of the first pre-charge unit 170 to electrically disconnect, controlling the first terminal and the second terminal of the second pre-charge unit 180 to electrically disconnect, and controlling charge sharing to perform between the predetermined voltage of the bit line and capacitance of the memory cell 20.

In some embodiments, in the first signal amplification stage, the method further includes:
controlling the first terminal and the second terminal of the fourth isolation unit 190 to electrically disconnect and the third terminal and the fourth terminal thereof to electrically disconnect, and controlling the first terminal, the third node C and the second terminal of the first signal amplification unit 110 to electrically connect, so that a voltage at the third node C is amplified to the second voltage or the first voltage.

In the second signal amplification stage, the method further includes:
controlling the first terminal and the second terminal of the first isolation unit 140 to electrically disconnect, controlling the first terminal and the second terminal of the fourth isolation unit 190 to electrically connect and the third terminal and the fourth terminal thereof to electrically connect, and controlling a first terminal and a third terminal of a third signal amplification unit 130 of the sense amplifier 10 to electrically connect or a second terminal and the third terminal thereof to electrically connect, so that a voltage of the first data signal line is amplified to the first voltage or the second voltage, so as to output the first voltage or the second voltage to a port.

In some embodiments, after the second signal amplification stage, the method further includes:
a second pre-charge stage, controlling the first terminal, the first node A and the second terminal of the first signal amplification unit 110 to electrically disconnect, controlling the first terminal, the third node C and the second terminal of the first signal amplification unit 110 to electrically disconnect, controlling the first terminal and the third terminal of the second signal amplification unit 120 to electrically disconnect and the second terminal and the third terminal thereof to electrically disconnect, controlling the first terminal and the third terminal of the third signal amplification unit 130 to electrically disconnect and the second terminal and the third terminal thereof to electrically disconnect, controlling the bit line to electrically disconnect from the memory cell 20, controlling the first terminal and the second terminal of the first pre-charge unit 170 to electrically connect, and controlling the first terminal and the second terminal of the second pre-charge unit 180 to electrically connect, so as to pre-charge the first node A, the third node C, the bit line and the first data signal line to a predetermined voltage.

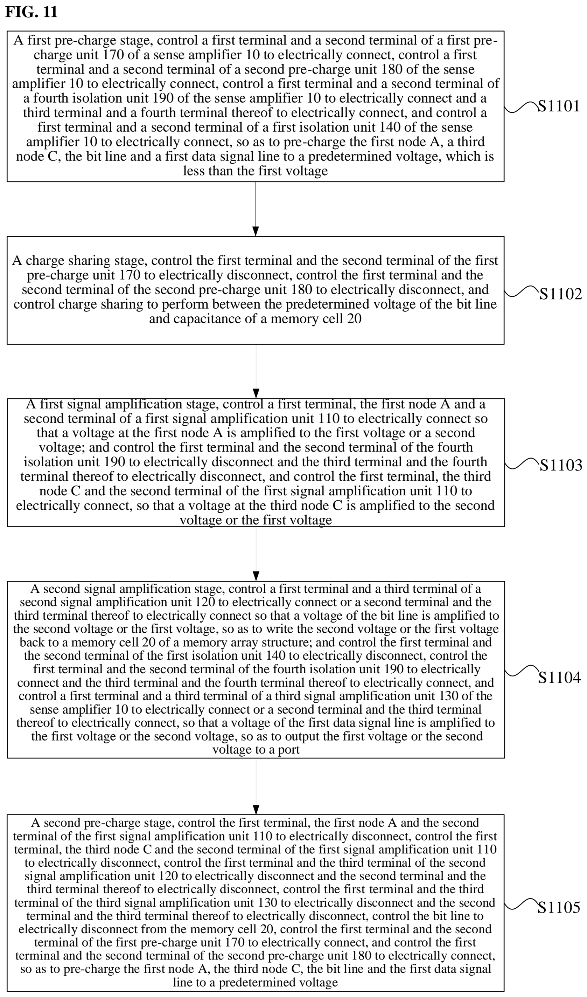

As an example, referring to FIG. 11, a first type of control method is provided, including:
S1101, a first pre-charge stage, controlling a first terminal and a second terminal of a first pre-charge unit 170 of a sense amplifier 10 to electrically connect, controlling a first terminal and a second terminal of a second pre-charge unit 180 of the sense amplifier 10 to electrically connect, controlling a first terminal and a second terminal of a fourth isolation unit 190 of the sense amplifier 10 to electrically connect and a third terminal and a fourth terminal thereof to electrically connect, and controlling a first terminal and a second terminal of a first isolation unit 140 of the sense amplifier 10 to electrically connect, so as to pre-charge a first node A, a third node C, a bit line and a first data signal line to a predetermined voltage, which is less than the first voltage;
S1102, a charge sharing stage, controlling the first terminal and the second terminal of the first pre-charge unit 170 to electrically disconnect, controlling the first terminal and the second terminal of the second pre-charge unit 180 to electrically disconnect, and controlling charge sharing to perform between the predetermined voltage of the bit line and capacitance of a memory cell 20;
S1103, a first signal amplification stage, controlling a first terminal, the first node A and a second terminal of a first signal amplification unit 110 to electrically connect so that a voltage at the first node A is amplified to the first voltage or a second voltage; and controlling the first terminal and the second terminal of the fourth isolation unit 190 to electrically disconnect and the third terminal and the fourth terminal thereof to electrically disconnect, and controlling the first terminal, the third node C and the second terminal of the first signal amplification unit 110 to electrically connect, so that a voltage at the third node C is amplified to the second voltage or the first voltage;
S1104, a second signal amplification stage, controlling a first terminal and a third terminal of a second signal amplification unit 120 to electrically connect or a second terminal and the third terminal thereof to electrically connect so that a voltage of the bit line is amplified to the second voltage or the first voltage, so as to write the second voltage or the first voltage back to a memory cell 20 of a memory array structure; and controlling the first terminal and the second terminal of the first isolation unit 140 to electrically disconnect, controlling the first terminal and the second terminal of the fourth isolation unit 190 to electrically connect and the third terminal and the fourth terminal thereof to electrically connect, and controlling a first terminal and a third terminal of a third signal amplification unit 130 of the sense amplifier 10 to electrically connect or a second terminal and the third terminal thereof to electrically connect, so that a voltage of the first data signal line is amplified to the first voltage or the second voltage, so as to output the first voltage or the second voltage to a port; and
S1105, a second pre-charge stage, controlling the first terminal, the first node A and the second terminal of the first signal amplification unit 110 to electrically disconnect, controlling the first terminal, the third node C and the second terminal of the first signal amplification unit 110 to electrically disconnect, controlling the first terminal and the third terminal of the second signal amplification unit 120 to electrically disconnect and the second terminal and the third terminal thereof to electrically disconnect, controlling the first terminal and the third terminal of the third signal amplification unit 130 to electrically disconnect and the second terminal and the third terminal thereof to electrically disconnect, controlling the bit line to electrically disconnect from the memory cell 20, controlling the first terminal and the second terminal of the first pre-charge unit 170 to electrically connect, and controlling the first terminal and the second terminal of the second pre-charge unit 180 to electrically connect, so as to pre-charge the first node A, the third node C, the bit line and the first data signal line to a predetermined voltage.

As an example, a first control method may include: a first signal amplification stage, controlling a first terminal, a first node A and a second terminal of a first signal amplification unit 110 to electrically connect so that a voltage at the first node A is amplified to a first voltage, and controlling a first terminal and a second terminal of a fourth isolation unit 190 to electrically disconnect and a third terminal and the fourth terminal thereof to electrically disconnect, and controlling the first terminal, a third node C and the second terminal of the first signal amplification unit 110 to electrically connect so that a voltage at the third node C is amplified to the second voltage; and
a second signal amplification stage, controlling a second terminal and a third terminal of a second signal amplification unit 120 to electrically connect so that a voltage at a bit line is amplified to the second voltage, so as to write the second voltage back to a memory cell 20 of a memory array structure, and controlling a first terminal and a second terminal of a first isolation unit 140 to electrically disconnect, controlling the first terminal and the second terminal of the fourth isolation unit 190 to electrically connect and the third terminal and the fourth terminal thereof to electrically connect, and controlling a first terminal and a third terminal of a third signal amplification unit 130 of a sense amplifier 10 to electrically connect so that a voltage of a first data signal line is amplified to the first voltage, so as to output the first voltage to a port.

Similarly, the first control method further includes: the first signal amplification stage, controlling the first terminal, the first node A and the second terminal of the first signal amplification unit 110 to electrically connect so that the voltage at the first node A is amplified to the second voltage, and controlling the first terminal and the second terminal of the fourth isolation unit 190 to electrically disconnect and the third terminal and the fourth terminal thereof to electrically disconnect, and controlling the first terminal, the third node C and the second terminal of the first signal amplification unit 110 to electrically connect so that the voltage at the third node C is amplified to the first voltage; and
the second signal amplification stage, controlling the first terminal and the third terminal of the second signal amplification unit 120 to electrically connect so that the voltage of the bit line is amplified to the first voltage, so as to write the first voltage back to the memory cell 20 of the memory array structure, and controlling a first terminal and a second terminal of a first isolation unit 140 to electrically disconnect, controlling the first terminal and the second terminal of the fourth isolation unit 190 to electrically connect and the third terminal and the fourth terminal thereof to electrically connect, and controlling the second terminal and the third terminal of the third signal amplification unit 130 of the sense amplifier 10 to electrically connect, so that the voltage of the first data signal line is amplified to the second voltage, so as to output the second voltage to the port.

In some embodiments, before the first signal amplification stage, the method further includes: a third pre-charge stage, controlling a first terminal and a second terminal of a first pre-charge unit 170 of the sense amplifier 10 to electrically connect, controlling a first terminal and a second terminal of a second pre-charge unit 180 of the sense amplifier 10 to electrically connect, controlling a first terminal and a second terminal of an offset cancellation unit 1100 of the sense amplifier 10 to electrically connect and a third terminal and a fourth terminal thereof to electrically connect, and controlling the first terminal and the second terminal of the first isolation unit 140 of the sense amplifier 10 to electrically connect, so as to pre-charge the first node A, the third node C, the bit line and the first data signal line to a predetermined voltage;
an offset cancellation stage, controlling the first terminal and the second terminal of the first pre-charge unit 170 to electrically disconnect, controlling the first terminal and the second terminal of the second pre-charge unit 180 to electrically disconnect, controlling the first terminal and the second terminal of the first isolation unit 140 to electrically disconnect, controlling the first terminal, the first node A and the second terminal of the first signal amplification unit 110 to electrically connect, and controlling the first terminal, the third node C and the second terminal of the first signal amplification unit 110 to electrically connect, so as to cancel offsets of threshold voltages of switch devices at a fourth terminal and a sixth terminal of the first signal amplification unit 110;
a fourth pre-charge stage, controlling the first terminal and the second terminal of the offset cancellation unit 1100 to electrically disconnect and the third terminal and the fourth terminal thereof to electrically disconnect, controlling the first terminal and the second terminal of the first pre-charge unit 170 to electrically connect, and controlling the first terminal and the second terminal of the second pre-charge unit 180 to electrically connect, so as to pre-charge the first node A and the third node C to a predetermined voltage; and
a charge sharing stage, controlling the first terminal and the second terminal of the first pre-charge unit 170 to electrically disconnect, controlling the first terminal and the second terminal of the second pre-charge unit 180 to electrically disconnect, and controlling charge sharing to perform between the predetermined voltage of the bit line and capacitance of the memory cell 20.

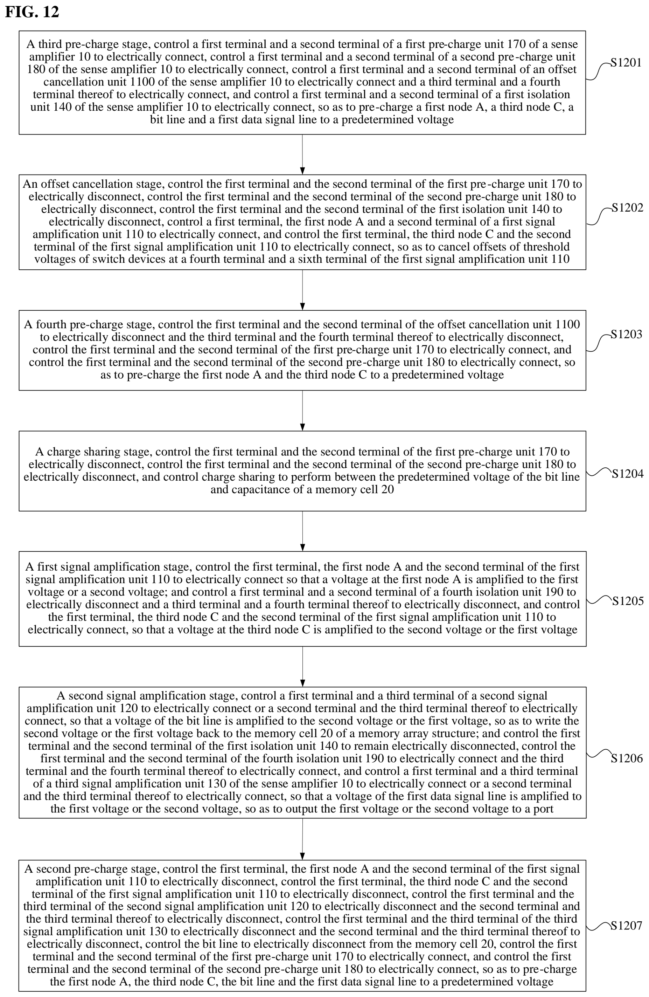

As an example, referring to FIG. 12, a second type of control method is provided, including:
S1201, a third pre-charge stage, controlling a first terminal and a second terminal of a first pre-charge unit 170 of a sense amplifier 10 to electrically connect, controlling a first terminal and a second terminal of a second pre-charge unit 180 of the sense amplifier 10 to electrically connect, controlling a first terminal and a second terminal of an offset cancellation unit 1100 of the sense amplifier 10 to electrically connect and a third terminal and a fourth terminal thereof to electrically connect, and controlling a first terminal and a second terminal of a first isolation unit 140 of the sense amplifier 10 to electrically connect, so as to pre-charge a first node A, a third node C, a bit line and a first data signal line to a predetermined voltage;
S1202, an offset cancellation stage, controlling the first terminal and the second terminal of the first pre-charge unit 170 to electrically disconnect, controlling the first terminal and the second terminal of the second pre-charge unit 180 to electrically disconnect, controlling the first terminal and the second terminal of the first isolation unit 140 to electrically disconnect, controlling a first terminal, the first node A and a second terminal of a first signal amplification unit 110 to electrically connect, and controlling the first terminal, the third node C and the second terminal of the first signal amplification unit 110 to electrically connect, so as to cancel offsets of threshold voltages of switch devices at a fourth terminal and a sixth terminal of the first signal amplification unit 110;

S1203, a fourth pre-charge stage, controlling the first terminal and the second terminal of the offset cancellation unit 1100 to electrically disconnect and the third terminal and the fourth terminal thereof to electrically disconnect, controlling the first terminal and the second terminal of the first pre-charge unit 170 to electrically connect, and controlling the first terminal and the second terminal of the second pre-charge unit 180 to electrically connect, so as to pre-charge the first node A and the third node C to a predetermined voltage;
S1204, a charge sharing stage, controlling the first terminal and the second terminal of the first pre-charge unit 170 to electrically disconnect, controlling the first terminal and the second terminal of the second pre-charge unit 180 to electrically disconnect, and controlling charge sharing to perform between the predetermined voltage of the bit line and capacitance of a memory cell 20;
S1205, a first signal amplification stage, controlling the first terminal, the first node A and the second terminal of the first signal amplification unit 110 to electrically connect so that a voltage at the first node A is amplified to the first voltage or a second voltage; and controlling a first terminal and a second terminal of a fourth isolation unit 190 to electrically disconnect and a third terminal and a fourth terminal thereof to electrically disconnect, and controlling the first terminal, the third node C and the second terminal of the first signal amplification unit 110 to electrically connect, so that a voltage at the third node C is amplified to the second voltage or the first voltage;
S1206, a second signal amplification stage, controlling a first terminal and a third terminal of a second signal amplification unit 120 to electrically connect or a second terminal and the third terminal thereof to electrically connect so that a voltage of the bit line is amplified to the second voltage or the first voltage, so as to write the second voltage or the first voltage back to the memory cell 20 of a memory array structure; and controlling the first terminal and the second terminal of the first isolation unit 140 to remain electrically disconnected, controlling the first terminal and the second terminal of the fourth isolation unit 190 to electrically connect and the third terminal and the fourth terminal thereof to electrically connect, and controlling a first terminal and a third terminal of a third signal amplification unit 130 of the sense amplifier 10 to electrically connect or a second terminal and the third terminal thereof to electrically connect, so that a voltage of the first data signal line is amplified to the first voltage or the second voltage, so as to output the first voltage or the second voltage to a port; and
S1207, a second pre-charge stage, controlling the first terminal, the first node A and the second terminal of the first signal amplification unit 110 to electrically disconnect, controlling the first terminal, the third node C and the second terminal of the first signal amplification unit 110 to electrically disconnect, controlling the first terminal and the third terminal of the second signal amplification unit 120 to electrically disconnect and the second terminal and the third terminal thereof to electrically disconnect, controlling the first terminal and the third terminal of the third signal amplification unit 130 to electrically disconnect and the second terminal and the third terminal thereof to electrically disconnect, controlling the bit line to electrically disconnect from the memory cell 20, controlling the first terminal and the second terminal of the first pre-charge unit 170 to electrically connect, and controlling the first terminal and the second terminal of the second pre-charge unit 180 to electrically connect, so as to pre-charge the first node A, the third node C, the bit line and the first data signal line to a predetermined voltage.

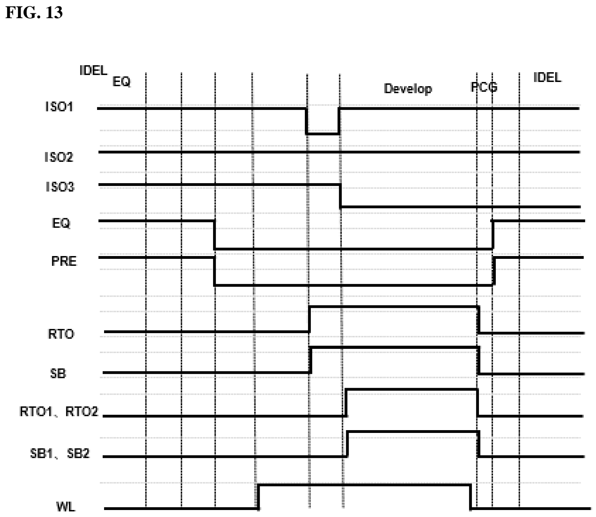

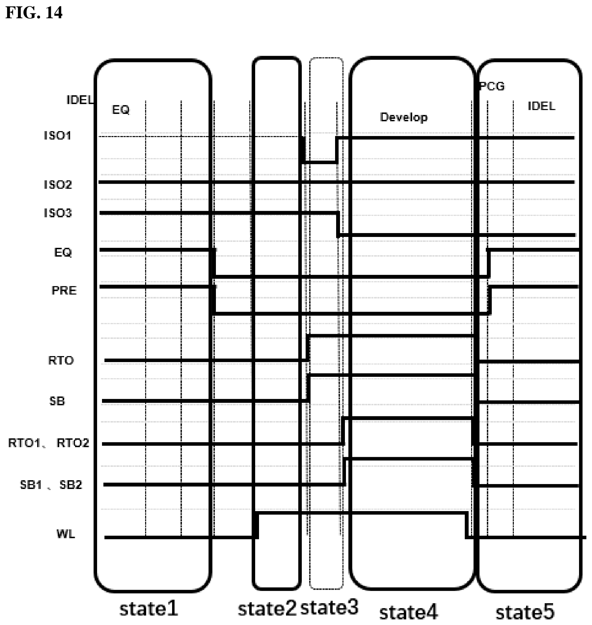

FIG. 13 and FIG. 14 illustrate a timing diagram of the first control method. The first control method includes five stages, i.e. a first pre-charge stage, a charge sharing stage, a first signal amplification stage, a second signal amplification stage and a second pre-charge stage, which respectively correspond to state1, state2, state3, state4 and state5. In the first type of control method, OC is omitted and signal amplification is performed twice, and the timing control method in FIG. 13 is used to read out data of a memory cell 20, which omits the enabling of OC, thereby normally reading stored data from the memory cell 20.

Referring to FIG. 7 and FIG. 14, the first type of control method includes:
a first pre-charge stage, in which EQ, ISO1, ISO2, ISO3 and PRE are activated, and SABL and SABLB, and BL and BLB are all pre-charged to 0.5 V with V_{BLEP};
a charge sharing stage, in which EQ and PRE are deactivated, WL, ISO1, ISO2 and ISO3 remain activated, and a charge sharing state is entered;
a first signal amplification stage, in which ISO1 is deactivated, WL, ISO2 and ISO3 remain activated, RTO and SB are activated, and a first instance of signal amplification is performed on SABL and SABLB using a sense amplifier SA;
a second signal amplification stage, in which ISO3 is deactivated, a reference power supply is isolated, WL, ISO1 and ISO2 are activated, a second instance of signal sense amplification is performed, RTO1 and SB1, and RTO2 and SB2 are activated to enable a data write-back function, and CSL is activated to provide a data readout function; and
a second pre-charge stage, WL is deactivated, RTO, RTO1, RTO2, SB, SB1 and SB2 are then deactivated, EQ and PRE are activated for enabling, and BL and BLB, and SABL and SABLB are charged to 0.5 V, such that a DRAM returns to an ideal state, preparing for the next instance of reading and writing.

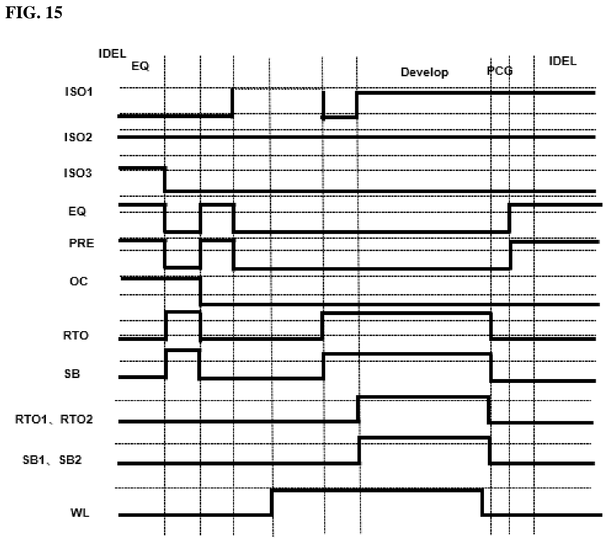

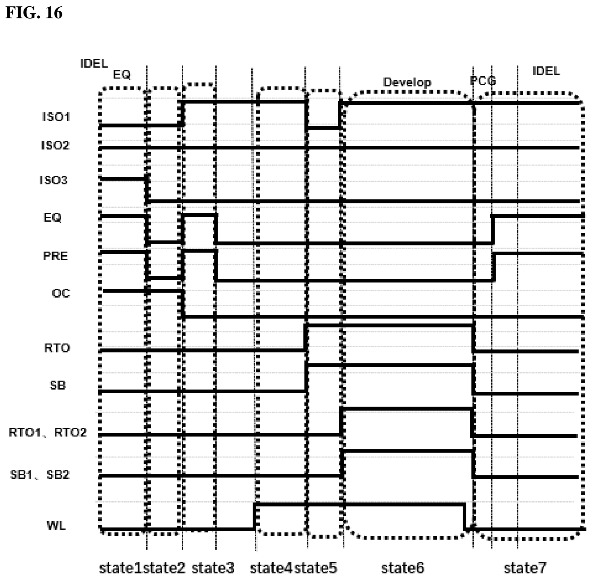

FIG. 15 and FIG. 16 illustrate a timing diagram of the second type of control method. The second type of control method includes seven stages, in which OC is reserved and signal amplification is performed twice. A third pre-charge stage, an offset cancellation stage, a fourth pre-charge stage, a charge sharing stage, a first signal amplification stage, a second signal amplification stage and a second pre-charge stage respectively correspond to state1, state2, state3, state4, state5, state6 and state7.

Referring to FIG. 7 and FIG. 16, the second type of control method includes:
a third pre-charge stage, in which EQ, ISO2, ISO3, PRE and OC are activated, and SABL and SABLB, and BL and BLB are all pre-charged to 0.5 V with VBLEP;
an offset cancellation stage, in which EQ and PRE are deactivated, OC, SB and RTO are activated, and a mismatch cancellation process is performed; and
a fourth pre-charge stage, in which OC is deactivated, EQ and PRE are activated, and SABL and SABLB are pre-charged to 0.5 V.

During the execution of the charge sharing stage, the first signal amplification stage, the second signal amplification stage and the second pre-charge stage of the first type of control method, it is necessary to maintain ISO3 deactivated, so as to isolate a reference power supply.

In the second control method, the timing control method in FIG. 15 is used to read out data of a memory cell 20, which reserves an enable mode of OC. Mismatched voltages of two amplification NMOSs (a switch device T7 and a switch device T8) may be normally sensed using this method, thereby improving the sense precision, and thus normally reading stored data in the memory cell 20.

It should be understood by those skilled in the art that steps, measures, and solutions in various operations, methods and processes that have been discussed in the present disclosure may be alternated, modified, combined, or deleted. Furthermore, other steps, measures, and solutions in the various operations, methods and processes that have been discussed in the present disclosure may also be alternated, modified, rearranged, decomposed, combined, or deleted. Furthermore, the steps, measures, and solutions in the various operations, methods and processes that are in the prior art and have been discussed in the present disclosure may also be alternated, modified, rearranged, decomposed, combined, or deleted.

The terms "first" and "second" are used for descriptive purposes only, and cannot be construed as indicating or implying relative importance or implicitly indicating the number of technical features indicated. Thus, the features defined with "first" and "second" may explicitly or implicitly include one or more features. In the description of the present disclosure, "a plurality of" means two or more, unless otherwise specified.

In the description of the present specification, the specific features, structures, materials or characteristics may be combined in a suitable manner in any one or more embodiments or examples.

It should be understood that although the steps in the flowcharts in the drawings are displayed in succession as indicated by arrows, these steps are not necessarily executed in succession in the order indicated by the arrows. Unless explicitly specified herein, the execution of these steps is not limited to a strict order, instead, the steps may be executed in another order. In addition, at least some steps in the flowcharts in the drawings may comprise multiple sub-steps or multiple stages. These sub-steps or stages are not necessarily executed or completed at the same moment, but may be executed at different times, and the order of execution thereof is also not necessarily in succession, but may be executed in turn or alternately with at least some other steps or sub-steps or stages of other steps.

The above are only some embodiments of the present disclosure, and it should be pointed out that for those of ordinary skill in the art, without departing from the principles of the present disclosure, several improvements and modifications may be made, and these improvements and modifications should also be regarded as the scope of protection of the present disclosure.

## Claims

1. A sense amplifier, comprising:
a first signal amplification unit, a first terminal and a second terminal of which are respectively used for being electrically connected to a first voltage terminal and a second voltage terminal, and a third terminal and a fourth terminal of which respectively serve as a first node and a second node, wherein the first voltage terminal is used for outputting the first voltage, the second voltage terminal is used for outputting the second voltage, and the first voltage is greater than the second voltage; and
a second signal amplification unit, a first terminal, a second terminal and a third terminal of which are respectively used for being electrically connected to a third voltage terminal, a fourth voltage terminal and a bit line, and a fourth terminal of which is electrically connected to the first node, wherein a voltage at the third voltage terminal is the same as a voltage at the first voltage terminal, and a voltage at the fourth voltage terminal is the same as a voltage at the second voltage terminal; the bit line is used for being electrically connected to a memory cell of a memory array structure; and
the sense amplifier is configured in such a way that the first terminal, the first node and the second terminal of the first signal amplification unit are electrically connected in a first signal amplification stage so that a voltage at the first node is amplified to the first voltage or the second voltage, and the first terminal and the third terminal of the second signal amplification unit are electrically connected or the second terminal and the third terminal thereof are electrically connected in a second signal amplification stage so that a voltage of the bit line is amplified to the second voltage or the first voltage, so as to write the second voltage or the first voltage back to the memory cell.

2. The sense amplifier according to claim 1, wherein a fifth terminal and a sixth terminal of the first signal amplification unit respectively serve as a third node and a fourth node;
the sense amplifier further comprises:
a third signal amplification unit, a first terminal, a second terminal and a third terminal of which are respectively used for being electrically connected to a fifth voltage terminal, a sixth voltage terminal and a first data signal line, and a fourth terminal of which is electrically connected to the third node; a voltage at the fifth voltage terminal is the same as the voltage at the first voltage terminal, and a voltage at the sixth voltage terminal is the same as the voltage at the second voltage terminal; the first data signal line is used for being electrically connected to a port; and
the sense amplifier is further configured in such a way that the first terminal, the third node and the second terminal of the first signal amplification unit are electrically connected in the first signal amplification stage so that a voltage at the third node is amplified to the second voltage or the first voltage, and the first terminal and the third terminal of the third signal amplification unit are electrically connected or the second terminal and the third terminal thereof are electrically connected in the second signal amplification stage so that a voltage of the first data signal line is amplified to the first voltage or the second voltage, so as to output the first voltage or the second voltage to the port.

3. The sense amplifier according to claim 2, further comprising:
a first isolation unit, a control terminal of which is used for being electrically connected to a first isolation signal line, and a first terminal and a second terminal of which are respectively used for being electrically connected to a first reference voltage terminal and the first data signal line,
wherein the first isolation unit is configured in such a way that the first terminal and the second terminal of the first isolation unit are electrically disconnected in the second signal amplification stage, so as to amplify the voltage of the first data signal line.

4. The sense amplifier according to claim 3, further comprising:
a second isolation unit, a control terminal and a first terminal of which are respectively used for being electrically connected to a second isolation signal line and the bit line, and a second terminal of which is electrically connected to the second node,
wherein the second isolation unit is configured in such a way that the first terminal and the second terminal of the second isolation unit are electrically connected when in an operating state, and the first terminal and the second terminal of the second isolation unit are electrically disconnected when in a non-operating state.

5. The sense amplifier according to claim 4, further comprising:
a third isolation unit, a control terminal of which is used for being electrically connected to a third isolation signal line, and a first terminal and a second terminal of which are electrically connected to the first data signal line and the fourth node, respectively, wherein the third isolation signal line is electrically connected to the second isolation signal line; and
the third isolation unit is configured in such a way that the first terminal and the second terminal of the third isolation unit are electrically connected when in an operating state, and the first terminal and the second terminal of the third isolation unit are electrically disconnected when in a non-operating state.

6. The sense amplifier according to claim 1, wherein the second signal amplification unit comprises a first switch module and a second switch module;
a control terminal of the first switch module and a control terminal of the second switch module together serve as the fourth terminal of the second signal amplification unit;
a first terminal of the first switch module serves as the first terminal of the second signal amplification unit;
a second terminal of the second switch module serves as the second terminal of the second signal amplification unit; and
a second terminal of the first switch module and a first terminal of the second switch module together serve as the third terminal of the second signal amplification unit.

7. The sense amplifier according to claim 2, wherein the third signal amplification unit comprises a third switch module and a fourth switch module;
a control terminal of the third switch module and a control terminal of the fourth switch module together serve as the fourth terminal of the third signal amplification unit;
a first terminal of the third switch module serves as the first terminal of the third signal amplification unit;
a second terminal of the fourth switch module serves as the second terminal of the third signal amplification unit; and
a second terminal of the third switch module and a first terminal of the fourth switch module together serve as the third terminal of the third signal amplification unit.

8. The sense amplifier according to claim 2, wherein the first signal amplification unit comprises a fifth switch module, a sixth switch module, a seventh switch module and an eighth switch module;
a first terminal of the fifth switch module and a first terminal of the sixth switch module together serve as the first terminal of the first signal amplification unit;
a second terminal of the fifth switch module and a first terminal of the seventh switch module together serve as the third terminal of the first signal amplification unit, and a second terminal of the sixth switch module and a first terminal of the eighth switch module together serve as the fifth terminal of the first signal amplification unit;
a second terminal of the seventh switch module and a second terminal of the eighth switch module together serve as the second terminal of the first signal amplification unit;
a control terminal of the fifth switch module is electrically connected to the third node, and a control terminal of the sixth switch module is electrically connected to the first node; and
a control terminal of the seventh switch module serves as the fourth terminal of the first signal amplification unit, and a control terminal of the eighth switch module serves as the sixth terminal of the first signal amplification unit.

9. The sense amplifier according to any one of claims 3-5, further comprising:
a first pre-charge unit, a control terminal of which is used for being electrically connected to a first signal line, a first terminal of which is used for being electrically connected to the first reference voltage terminal, and a second terminal of which is electrically connected to the third node, wherein the first reference voltage terminal is used for outputting a first reference voltage;
a second pre-charge unit, a control terminal of which is used for being electrically connected to a second signal line, and a first terminal and a second terminal of which are electrically connected to the first node and the third node, respectively; and
a fourth isolation unit, a control terminal of which is used for being electrically connected to a fourth isolation signal line, and a first terminal, a second terminal, a third terminal and a fourth terminal of which are electrically connected to the second node, the third node, the first node and the fourth node, respectively.

10. The sense amplifier according to claim 9, further comprising:
an offset cancellation unit, a control terminal of which is used for being electrically connected to an offset cancellation signal line, and a first terminal, a second terminal, a third terminal and a fourth terminal of which are electrically connected to the second node, the first node, the third node and the fourth node, respectively.

11. The sense amplifier according to claim 9, wherein the fourth isolation unit comprises: a ninth switch module and a tenth switch module;
a control terminal of the ninth switch module and a control terminal of the tenth switch module together serve as the control terminal of the fourth isolation unit;
a first terminal and a second terminal of the ninth switch module respectively serve as the second terminal and the first terminal of the fourth isolation unit; and
a first terminal and a second terminal of the tenth switch module respectively serve as the third terminal and the fourth terminal of the fourth isolation unit.

12. The sense amplifier according to claim 10, wherein the offset cancellation unit comprises: an eleventh switch module and a twelfth switch module,
wherein a control terminal of the eleventh switch module and a control terminal of the twelfth switch module together serve as the control terminal of the offset cancellation unit;
a first terminal and a second terminal of the eleventh switch module respectively serve as the second terminal and the first terminal of the offset cancellation unit; and
a first terminal and a second terminal of the twelfth switch module respectively serve as the third terminal and the fourth terminal of the offset cancellation unit.

13. A memory array structure, comprising: a plurality of bit lines, a plurality of word lines, a plurality of memory cells, which are distributed in a matrix, and a plurality of sense amplifiers according to any one of claims 1-12,
wherein one of the bit lines is correspondingly electrically connected to one column of the memory cells;
one of the word lines is correspondingly electrically connected to one row of the memory cells; and
each of the bit lines is correspondingly electrically connected to a third terminal of a second signal amplification unit of one of the sense amplifiers.

14. A dynamic random access memory, comprising: the memory array structure according to claim 13.

15. An electronic device, comprising: the memory array structure according to claim 13, or the dynamic random access memory according to claim 14.

16. A control method applied to the sense amplifier according to any one of claims 1-12, comprising:
a first signal amplification stage, controlling a first terminal, a first node and a second terminal of a first signal amplification unit to electrically connect so that a voltage at the first node is amplified to a first voltage or a second voltage; and
a second signal amplification stage, controlling a first terminal and a third terminal of a second signal amplification unit to electrically connect or a second terminal and the third terminal thereof to electrically connect, so that a voltage of a bit line is amplified to the second voltage or the first voltage, so as to write the second voltage or the first voltage back to a memory cell of a memory array structure.

17. The control method according to claim 16, further comprising, before the first signal amplification stage:
a first pre-charge stage, controlling a first terminal and a second terminal of a first pre-charge unit of the sense amplifier to electrically connect, controlling a first terminal and a second terminal of a second pre-charge unit of the sense amplifier to electrically connect, controlling a first terminal and a second terminal of a fourth isolation unit of the sense amplifier to electrically connect and a third terminal and a fourth terminal thereof to electrically connect, and controlling a first terminal and a second terminal of a first isolation unit of the sense amplifier to electrically connect, so as to pre-charge a first node, a third node, the bit line and a first data signal line to a predetermined voltage, wherein the predetermined voltage is less than the first voltage; and
a charge sharing stage, controlling the first terminal and the second terminal of the first pre-charge unit to electrically disconnect, controlling the first terminal and the second terminal of the second pre-charge unit to electrically disconnect, and controlling charge sharing to perform between the predetermined voltage of the bit line and capacitance of the memory cell.

18. The control method according to claim 17, wherein in the first signal amplification stage, the method further comprises:
controlling the first terminal and the second terminal of the fourth isolation unit to electrically disconnect and the third terminal and the fourth terminal thereof to electrically disconnect, and controlling the first terminal, the third node and the second terminal of the first signal amplification unit to electrically connect, so that a voltage at the third node is amplified to the second voltage or the first voltage; and
in the second signal amplification stage, the method further comprises:
controlling the first terminal and the second terminal of the first isolation unit to electrically disconnect, controlling the first terminal and the second terminal of the fourth isolation unit to electrically connect and the third terminal and the fourth terminal thereof to electrically connect, and controlling a first terminal and a third terminal of a third signal amplification unit of the sense amplifier to electrically connect or a second terminal and the third terminal thereof to electrically connect, so that a voltage of the first data signal line is amplified to the first voltage or the second voltage, so as to output the first voltage or the second voltage to a port.

19. The control method according to claim 18, further comprising, after the second signal amplification stage:
a second pre-charge stage, controlling the first terminal, the first node and the second terminal of the first signal amplification unit to electrically disconnect, controlling the first terminal, the third node and the second terminal of the first signal amplification unit to electrically disconnect, controlling the first terminal and the third terminal of the second signal amplification unit to electrically disconnect and the second terminal and the third terminal thereof to electrically disconnect, controlling the first terminal and the third terminal of the third signal amplification unit to electrically disconnect and the second terminal and the third terminal thereof to electrically disconnect, controlling the bit line to electrically disconnect from the memory cell, controlling the first terminal and the second terminal of the first pre-charge unit to electrically connect, and controlling the first terminal and the second terminal of the second pre-charge unit to electrically connect, so as to pre-charge the first node, the third node, the bit line and the first data signal line to a predetermined voltage.

20. The control method according to claim 16, further comprising, before the first signal amplification stage:
a third pre-charge stage, controlling the first terminal and the second terminal of the first pre-charge unit of the sense amplifier to electrically connect, controlling the first terminal and the second terminal of the second pre-charge unit of the sense amplifier to electrically connect, controlling a first terminal and a second terminal of an offset cancellation unit of the sense amplifier to electrically connect and a third terminal and a fourth terminal thereof to electrically connect, and controlling the first terminal and the second terminal of the first isolation unit of the sense amplifier to electrically connect, so as to pre-charge the first node, the third node, the bit line and the first data signal line to a predetermined voltage;
an offset cancellation stage, controlling the first terminal and the second terminal of the first pre-charge unit to electrically disconnect, controlling the first terminal and the second terminal of the second pre-charge unit to electrically disconnect, controlling the first terminal and the second terminal of the first isolation unit to electrically disconnect, controlling the first terminal, the first node and the second terminal of the first signal amplification unit to electrically connect, and controlling the first terminal, the third node and the second terminal of the first signal amplification unit to electrically connect, so as to cancel offsets of threshold voltages of switch devices at the fourth terminal and the sixth terminal of the first signal amplification unit;
a fourth pre-charge stage, controlling the first terminal and the second terminal of the offset cancellation unit to electrically disconnect and the third terminal and the fourth terminal thereof to electrically disconnect, controlling the first terminal and the second terminal of the first pre-charge unit to electrically connect, and controlling the first terminal and the second terminal of the second pre-charge unit to electrically connect, so as to pre-charge the first node and the third node to a predetermined voltage; and
a charge sharing stage, controlling the first terminal and the second terminal of the first pre-charge unit to electrically disconnect, controlling the first terminal and the second terminal of the second pre-charge unit to electrically disconnect, and controlling charge sharing to perform between the predetermined voltage of the bit line and capacitance of the memory cell.

21. The control method according to claim 20, further comprising, after the second signal amplification stage:
a second pre-charge stage, controlling the first terminal, the first node and the second terminal of the first signal amplification unit to electrically disconnect, controlling the first terminal, the third node and the second terminal of the first signal amplification unit to electrically disconnect, controlling the first terminal and the third terminal of the second signal amplification unit to electrically disconnect and the second terminal and the third terminal thereof to electrically disconnect, controlling the first terminal and the third terminal of the third signal amplification unit to electrically disconnect and the second terminal and the third terminal thereof to electrically disconnect, controlling the bit line to electrically disconnect from the memory cell, controlling the first terminal and the second terminal of the first pre-charge unit to electrically connect, and controlling the first terminal and the second terminal of the second pre-charge unit to electrically connect, so as to pre-charge the first node, the third node, the bit line and the first data signal line to a predetermined voltage.
